(19) **Europäisches Patentamt / European Patent Office / Office européen des brevets**

(11) **EP 4 723 425 A1**

(12) **EUROPEAN PATENT APPLICATION**
published in accordance with Art. 153(4) EPC

(43) Date of publication:
08.04.2026 Bulletin 2026/15

(21) Application number: 24832426.1

(22) Date of filing: 26.06.2024

(51) International Patent Classification (IPC):
H02J 7/04 (2006.01)      H02J 7/00 (2026.01)
G01R 19/165 (2006.01)      G01R 27/16 (2006.01)
H01M 10/44 (2006.01)

(52) Cooperative Patent Classification (CPC):
G01R 19/165; G01R 27/16; H01M 10/44;
H02J 7/00; H02J 7/04

(86) International application number:
PCT/KR2024/008879

(87) International publication number:
WO 2025/005648 (02.01.2025 Gazette 2025/01)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 27.06.2023 KR 20230082982
16.08.2023 KR 20230106775

(71) Applicant: Samsung Electronics Co., Ltd.
Suwon-si, Gyeonggi-do 16677 (KR)

(72) Inventor: LEE, Kyunghwan
Suwon-si Gyeonggi-do 16677 (KR)

(74) Representative: Appleyard Lees IP LLP
G Mill
Dean Clough Industrial Park
Halifax HX3 5AH (GB)

(54) **ELECTRONIC DEVICE AND OPERATION METHOD THEREOF**

(57) This electronic device may comprise: a connector for a connection to an external power source; a charging circuit for converting the power provided through the connector; a battery for receiving the power through the charging circuit; and a controller operatively and/or electrically connected to the charging circuit. The controller can be configured to: identify information related to charging; identify a first voltage conversion ratio of the charging circuit on the basis of the information related to charging; control the charging circuit so as to convert, on the basis of the first voltage conversion ratio, the power provided through the connector; identify, on the basis of the information related to charging, a second voltage conversion ratio that differs from the first voltage conversion ratio of the charging circuit while the battery is being charged on the basis of the first voltage conversion ratio; and control the charging circuit so as to convert, on the basis of the second voltage conversion ratio, the power provided through the connector.

START

IDENTIFY CHARGING-RELATED INFORMATION — 201

IDENTIFY FIRST VOLTAGE CONVERSION RATIO — 203

CONTROL CHARGER CIRCUIT ACCORDING TO FIRST VOLTAGE CONVERSION RATIO — 205

CONVERT POWER, BASED ON FIRST VOLTAGE CONVERSION RATIO — 207

IDENTIFY SECOND VOLTAGE CONVERSION RATIO — 209

CONTROL CHARGER CIRCUIT ACCORDING TO SECOND VOLTAGE CONVERSION RATIO — 211

CONVERT POWER, BASED ON SECOND VOLTAGE CONVERSION RATIO — 213

END

FIG. 2

Processed by Luminess, 75001 PARIS (FR)

## Description

[Technical Field]

Embodiments of the disclosure relate to an electronic device for identifying a voltage conversion ratio of a charging circuit and a method of operating the same.

[Background Art]

Recently, as the movement and portability of electronic devices have been emphasized, light and slim designs are required, and specifications and performance operations having a tradeoff relationship therewith are continuously required to be improved above the past level, and the battery capacity of electronic devices is continuously increasing.

When an external power source (for example, adaptor) is connected to the electronic device, a battery may be charged through a charging circuit of the electronic device. For example, the electronic device may recognize that the external power source is connected to a terminal (for example, connector) and transmit a command related to a charging current and charging voltage of the battery corresponding to maximum power supported by the corresponding power source to the charging circuit. The charging circuit of the electronic device may start charging the battery, based on the command related to the charging current and charging voltage of the battery. The charging circuit of the electronic device may convert power provided from the external power source into charging power for charging the battery. A conversion ratio between the input voltage into the charging circuit and the output voltage from the charging circuit may be fixed, and, for example, the electronic device may receive the input voltage that is about twice the battery voltage and charge the battery with the charging current that is twice the input current.

[Detailed Description of the Invention]

[Technical Solution]

According to an embodiment, an electronic device may include a connector for a connection with an external power source, a charging circuit configured to convert power provided through the connector, a battery configured to receive power through the charging circuit, and a controller operatively and/or electrically connected to the charging circuit. The controller may be configured to identify charging-related information. The controller may be configured to identify a first voltage conversion ratio of the charging circuit, based on the charging-related information. The controller may be configured to control the charging circuit to convert power provided through the connector, based on the first voltage conversion ratio. The controller may be configured to identify a second voltage conversion ratio different from the first voltage conversion ratio of the charging circuit, based on the charging-related information while the battery is charged based on the first voltage conversion ratio. The controller may be configured to control the charging circuit to convert power provided through the connector, based on the second voltage conversion ratio.

According to an embodiment, a method of operating an electronic device may include identifying charging-related information. The method may include identifying a first voltage conversion ratio of a charging circuit of the electronic device, based on the charging-related information. The method may include controlling the charging circuit to convert power provided through a connector of the electronic device for a connection with an external power source, based on the first voltage conversion ratio. The method may include identifying a second voltage conversion ratio different from the first voltage conversion ratio of the charging circuit while the battery of the electronic device is charged based on the first voltage conversion ratio. The method may include controlling the charging circuit to convert power provided through the connector, based on the second voltage conversion ratio.

According to an embodiment, a computer-readable recording medium storing instructions configured to cause a processor of an electronic device to perform at least one operation may be provided. The at least one operation may include identifying charging-related information. The at least one operation may include identifying a first voltage conversion ratio of a charging circuit of the electronic device, based on the charging-related information. The at least one operation may include controlling the charging circuit to convert power provided through a connector of the electronic device for a connection with an external power source, based on the first voltage conversion ratio. The at least one operation may include identifying a second voltage conversion ratio different from the first voltage conversion ratio of the charging circuit while the battery of the electronic device is charged based on the first voltage conversion ratio. The at least one operation may include controlling the charging circuit to convert power provided through the connector, based on the second voltage conversion ratio.

[Brief Description of Drawings]

FIG. 1 is a block diagram of the electronic device according to an embodiment.
FIG. 2 is a flowchart illustrating a method of operating the electronic device according to an embodiment.
FIG. 3 is a flowchart illustrating a method of operating the electronic device according to an embodiment.
FIG. 4 is a flowchart illustrating a method of operating the electronic device according to an embodiment.
FIG. 5 is a flowchart illustrating a method of operating the electronic device according to an embodiment.

FIG. 6 is a diagram illustrating an operation of the electronic device according to an embodiment.

FIG. 7 is a diagram illustrating an operation of the electronic device according to an embodiment.

FIG. 8 is a flowchart illustrating a method of operating the electronic device according to an embodiment.

FIG. 9 is a flowchart illustrating a method of operating the electronic device according to an embodiment.

FIG. 10 is a diagram illustrating an operation of the electronic device according to an embodiment.

FIG. 11 is a circuit diagram illustrating a charging circuit of the electronic device according to an embodiment.

FIG. 12 is a circuit diagram illustrating the charging circuit of the electronic device according to an embodiment.

FIG. 13 is a circuit diagram illustrating the charging circuit of the electronic device according to an embodiment.

FIG. 14 is a circuit diagram illustrating the charging circuit of the electronic device according to an embodiment.

[Mode for Carrying out the Invention]

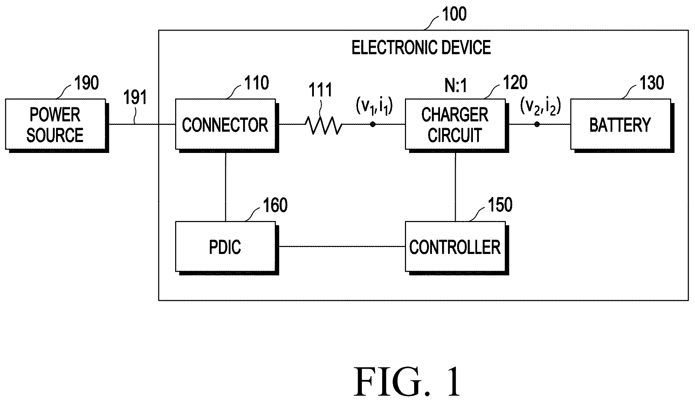

FIG. 1 is a block diagram of an electronic device according to an embodiment.

Referring to FIG. 1, according to an embodiment, an electronic device 100 may be a device receiving power from a power source 190. The power source 190 may be a device providing power from the electronic device 100. The power source 190 may be a device transferring power to the electronic device 100. For example, the power source 190 may be a travel adaptor (TA) supporting programmable power supply (PPS), but may be a device which does not support the PPS, and the power source 190 is a device providing or transmitting power and there is no limitation on the type. The electronic device 100 is a device receiving power and there is no limitation on the type.

According to an embodiment, the electronic device 100 may include a connector 110. The connector 110 is a component for the connection with the power source 190 and, for example, a universal serial bus (USB) port but there is no limitation on the type of the connector 110. A cable 191 for the connection with the power source 190 may be connected to the connector 110. The electronic device 100 may receive power form the power source 190 through the connector 110.

According to an embodiment, the electronic device 100 may include a charging circuit 120 and a battery 130. The charging circuit 120 may provide power to the battery 130, based on power provided from the external power source 190. The charging circuit 120 may convert the input power (for example, input voltage and input current) of the charging circuit 120 and output the output power (for example, output voltage and output current). $v_1$ of FIG. 1 may be the input voltage of the

charging circuit 120. $i_1$ of FIG. 1 may be the input current of the charging circuit 120. $v_2$ of FIG. 1 may be the output voltage of the charging circuit 120. $i_2$ of FIG. 1 may be the output current of the charging circuit 120. $v_2$ of FIG. 1 may be the input voltage (for example, charging voltage) of the battery 130. $i_2$ of FIG. 1 may be the input current (for example, charging current) of the battery 130. The charging circuit 120 may convert the input voltage $v_1$ into the output voltage $v_2$. The charging circuit 120 may convert the input current $i_1$ into the output current $i_2$. The battery 130 may be charged based on charging power (for example, the output voltage $v_2$ (for example, charging voltage) and/or the output current $i_2$ (for example, charging current)) provided by the charging circuit 120.

According to an embodiment, the electronic device 100 may include a controller 150. The controller 150 (for example, processor) may control at least one component (for example, hardware or software component) of the electronic device 100 connected to the controller 150 by executing, for example, software (for example, program) and may perform various data processing or calculations. According to an embodiment, as at least a part of the data processing or calculations, the controller 150 may store a command or data received from another component, process the command or data stored in memory, and store resultant data in the memory. According to an embodiment, the controller 150 may include a main processor (for example, a central processing unit or an application processor) or an auxiliary processor (for example, a graphic processing unit, a neural processing unit (NPU), an image signal processor, a sensor hub processor, or a communication processor) which may operate independently from the main processor or together with the main processor. For example, when the electronic device 100 includes the main processor and the auxiliary processor, the auxiliary processor may be configured to use lower power than the main processor or be specialized in a predetermined function. The auxiliary processor may be implemented to separate from the main processor or to be a part of the main processor. The auxiliary processor may control, for example, at least some of the functions or states related to at least one component among the components of the electronic device 100 on behalf of the main processor while the main processor is in an inactive (for example, sleep) state or together with the main processor while the main processor is in an active (for example, application execution) state. According to an embodiment, the auxiliary processor (for example, an image signal processor or a communication processor) may be implemented as a part of another functionally relevant component (for example, a camera module or a communication module). According to an embodiment, the auxiliary processor (for example, a neural network processing unit) may include a hardware structure specialized in processing of an artificial intelligence model. The artificial intelligence model may be generated through machine learning. Such learning may be performed by, for example, the electronic device 100 itself in which the artificial intelligent model is executed or may be performed through a separate server. A learning algorithm may include, for example, supervised learning, unsupervised learning, semi-supervised learning, or reinforcement learning, but is not limited thereto. The artificial intelligence model may include a plurality of artificial neural network layers. The artificial neural network may be one of a deep neural network (DNN), a convolutional neural network (CNN), a recurrent neural network (RNN), a restricted Boltzmann machine (BBM), a deep belief network (DBN), a bidirectional recurrent deep neural network (BRDNN), deep Q-networks, or a combination of two or more thereof, but is not limited thereto. The artificial intelligence model may additionally or alternatively include a software structure as well as the hardware structure. The memory of the electronic device 100 may store various pieces of data used by at least one component (for example, controller 150) of the electronic device 100. The data may include, for example, software (for example, program) and input data or output data for a command related thereto. The memory of the electronic device 100 may include volatile memory or non-volatile memory. The program may be stored in the memory of the electronic device 100 as software, and may include, for example, an operating system, middleware, or an application.

According to an embodiment, the controller 150 of the electronic device 100 may be read various pieces of information while being connected to the battery 130, and perform various and appropriate logic operations, based on the information. The charging voltage (for example, $v_2$) of the battery 130 may vary within a charging voltage range of the battery 130. The controller 150 may configure the charging voltage (for example, $v_2$) and the charging current (for example, $i_2$) of the battery 130 and control the charging circuit 120, based on information on the configured charging voltage and charging current.

According to an embodiment, the electronic device 100 may include a power delivery integrated circuit (PDIC) 160. The PDIC 160 may identify a device connected to the connector 110 (for example, USB port) through USB communication and transfer information on the identified device to the controller 150 through an inter integrated circuit (I2C). The controller 150 may recognize that a travel adaptor (TA) supporting the power source 190 (for example, programmable power supply (PPS)) is connected to the connector 110, based on the information from the PDCI 160 and transmit an I2C command for the charging current and charging voltage of the battery 130 corresponding to maximum power supported by the power source 190 to the charging circuit 120.

According to an embodiment, the charging circuit 120 may convert the input voltage (for example, $v_1$) into the output voltage (for example, $v_2$), based on a voltage conversion ratio (for example, N of FIG. 1). The "voltage conversion ratio" (for example, N of FIG. 1) of the charging circuit 120 may be a ratio of the input voltage (for example, $v_1$) to the output voltage (for example, $v_2$) [Equation 1].

$$[\text{Equation 1}]\ v_1{:}v_2 = N{:}1$$

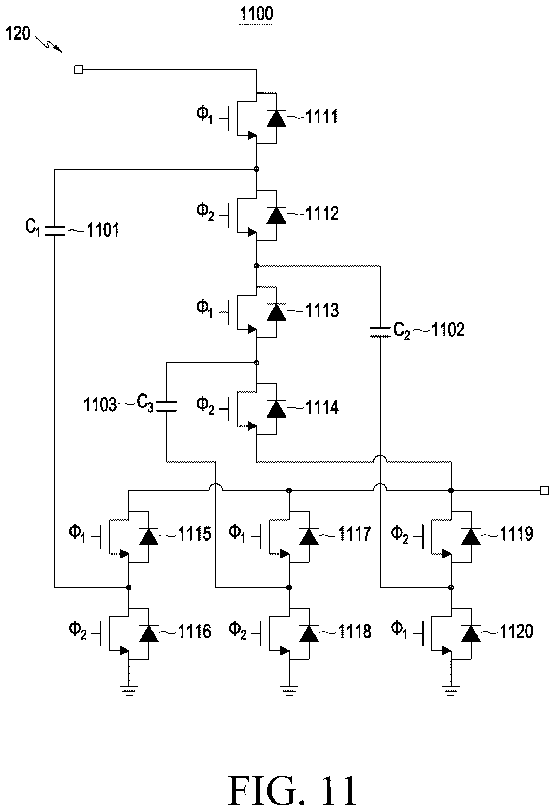

According to an embodiment, the charging circuit 120 may be a circuit having a variable voltage conversion ratio. For example, when the voltage conversion ratio of the charging circuit 120 is $N_1$, $v_2 = v_1/N_1$ and $i_2 = N_1 * i_1$. For example, when the voltage conversion ratio of the charging circuit 120 is $N_2$, $v_2 = v_1/N_2$ and $i_2 = N_2 * i_1$. The charging circuit 120 may include at least one switch. The controller 150 may adjust the voltage conversion ratio of the charging circuit 120 by controlling the charging circuit 120. The controller 150 may adjust the voltage conversion ratio of the charging circuit 120 by controlling at least one switch of the charging circuit 120. The structure of the charging circuit 120 is described in detail with reference to FIGS. 11, 12, 13, and 14.

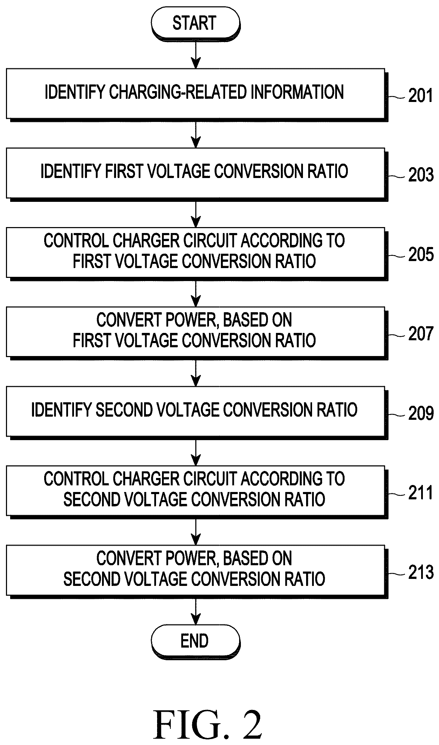

FIG. 2 is a flowchart illustrating a method of operating the electronic device according to an embodiment. FIG. 2 may be described with reference to the previously described embodiment.

At least some of the operations in FIG. 2 may be omitted. The order of the operations in FIG. 2 may be changed. Operations other than the operations of FIG. 2 may be performed before, during, or after the operations of FIG. 2.

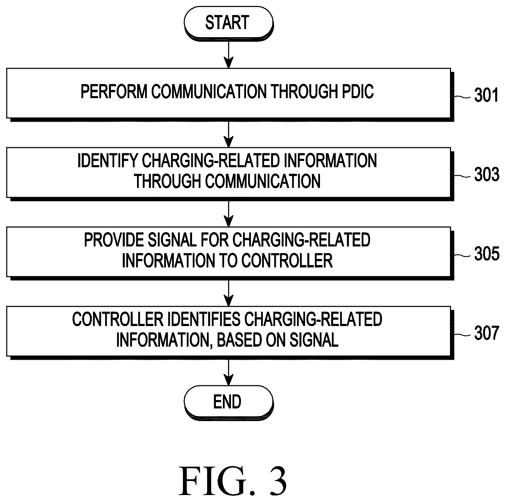

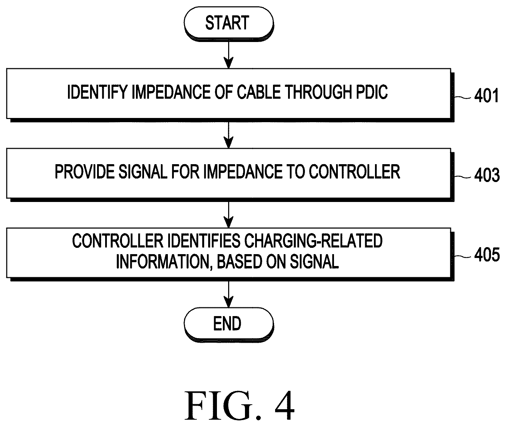

Referring to FIG. 2, in operation 201, according to an embodiment, the electronic device 100 (for example, the controller 150) may identify charging-related information. For example, the "charging-related information" may include at least one piece of information on the cable 191 connected to the connector 110 (for example, information on the type of the cable 191 or the maximum allowable current supported by the cable 191 (for example, impedance information or authentication information)), information on power (suppliable voltage and current) supported by the power source 190, or information on charging power (for example, charging voltage and charging current, and/or input voltage and input current) for charging the battery 130. An embodiment in which the electronic device 100 identifies the charging-related information is described in detail with reference to FIGS. 3 and 4.

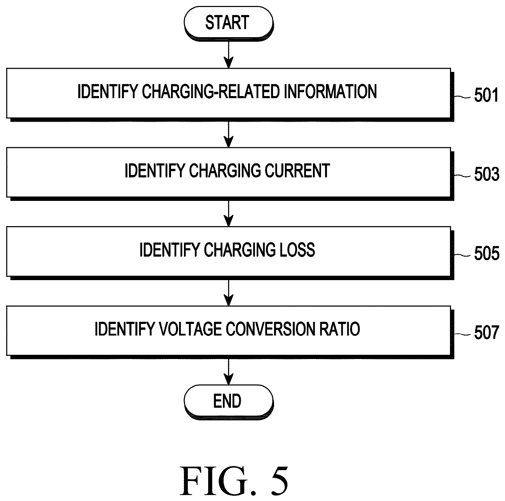

In operation 203, according to an embodiment, the electronic device 100 (for example, the controller 150) may identify a first voltage conversion ratio of the charging circuit 120, based on the charging-related information. For example, the electronic device 100 may identify the voltage conversion ratio (for example, an optimal voltage conversion ratio), based on charging power (for example, charging voltage or charging current) of the battery 130 corresponding to the charging-related information and/or charging loss of the electronic device 100. An embodiment in which the electronic device 100 identifies the voltage conversion ratio is described in detail with reference to FIG. 5.

In operation 205, according to an embodiment, the electronic device 100 (for example, the controller 150) may control the charging circuit 120 to convert power provided through the connector 110, based on the first voltage conversion ratio identified in operation 203. The electronic device 100 may control at least one switch included in the charging circuit 120, based on the first voltage conversion ratio.

In operation 207, according to an embodiment, the electronic device 100 (for example, the controller 150) may convert power provided from the power source 190 to the charging circuit 120 through the cable 191 and the connector 110, based on the first voltage conversion ratio. The charging circuit 120 may convert the input voltage (for example, $v_1$ of FIG. 1) into the output voltage (for example, $v_2$ of FIG. 1), based on the first voltage conversion ratio. The battery 130 may be charged by the charging voltage (for example, $v_2$ of FIG. 1), based on the first voltage conversion ratio.

In operation 209, according to an embodiment, the electronic device 100 (for example, the controller 150) may identify a second voltage conversion ratio of the charging circuit 120, based on the charging-related information. The electronic device 100 may identify the second voltage conversion ratio different form the first voltage conversion ratio of the charging circuit 120, based on the charging-related information while the battery 130 is charged based on the first voltage conversion ratio. For example, as the charging of the battery 130 is progressed based on the first voltage conversion ratio, charging power (for example, charging voltage and/or charging current) required by the battery 130 may be changed. Accordingly, the electronic device 100 may identify the second voltage conversion ratio different from the first voltage conversion ratio, based on the charging-related information and/or charging loss of the electronic device 100.

In operation 211, according to an embodiment, the electronic device 100 (for example, the controller 150) may control the charging circuit 120 to convert power provided through the connector 110, based on the second voltage conversion ratio identified in operation 209. The electronic device 100 may control at least one switch included in the charging circuit 120, based on the second voltage conversion ratio.

In operation 213, according to an embodiment, the electronic device 100 (for example, the controller 150) may convert power provided from the power source 190, based on the second voltage conversion ratio. The charging circuit 120 may convert the input voltage (for example, $v_1$ of FIG. 1) into the output voltage (for example, $v_2$ of FIG. 1), based on the second voltage conversion ratio. The battery 130 may be charged by the charging voltage (for example, $v_2$ of FIG. 1), based on the second voltage conversion ratio.

FIG. 3 is a flowchart illustrating a method of operating the electronic device according to an embodiment. FIG. 3 may be described with reference to the previously described embodiment.

Referring to FIG. 3, an embodiment in which the electronic device 100 identifies at least one piece of the charging-related information (for example, the information on the cable 191 connected to the connector 110 (for example, information on the type of the cable 191 or the maximum allowable current supported by the cable 191 (for example, impedance information or authentication information)), the information on the power (for example, suppliable voltage and current) supported by the power source 190, or the information on the charging power (for example, charging voltage and charging current or input voltage and input current) for charging the battery 130) may be understood.

At least some of the operations in FIG. 3 may be omitted. The order of the operations in FIG. 3 may be changed. Operations other than the operations of FIG. 3 may be performed before, during, or after the operations of FIG. 3.

Referring to FIG. 3, in operation 301, according to an embodiment, the electronic device 100 (for example, the controller 150) may communicate with the power source 190 through the PDIC 160. The electronic device 100 may perform communication (for example, USB communication) with the power source 190 (for example, a TA supporting PPS) connected through the connector 110 by using the PDIC 160.

In operation 303, according to an embodiment, the electronic device 100 (for example, the controller 150) may identify charging-related information through the communication with the power source 190 using the PDIC 160. For example, the PDIC 160 may identify the power source 190 connected to the connector 110 (for example, USB port) through USB communication. For example, the PDIC 160 may identify charging-related information corresponding to the power source 190 (for example, the information on the cable 191 connected to the connector 110 (for example, the information on the type of the cable 191 or the maximum allowable current supported by the cable 191 (for example, impedance information or authentication information)), the information on the power (for example, suppliable voltage and current) supported by the power source 190, or the information on the charging power (for example, charging voltage and charging circuit or input voltage and input current) for charging the battery 130).

In operation 305, according to an embodiment, the electronic device 100 (for example, the controller 150) may control the PDIC 160 to provide a signal for the charging-related information identified in operation 303. For example, the PDIC 160 may identify the charging-related information and provide a signal for the identified information to the controller 150 in operation 303.

In operation 307, according to an embodiment, the electronic device 100 (for example, the controller 150) may identify the charging-related information, based on the signal provided from the PDIC 160. For example, the controller 150 may identify at least one piece of the information on the cable 191 connected to the connector 110 (for example, the information on the type of the cable 191 or the maximum allowable current (for example, impedance information or authentication information) supported by the cable 191)), the information on power (for example, suppliable voltage and current) supported by the power source 190, or the information on the charging power (for example, charging voltage and charging circuit or input voltage and input current) for charging the battery 130), based on the charging-related information provided by the PDCI 160 and/or the charging circuit 120.

FIG. 4 is a flowchart illustrating a method of operating the electronic device according to an embodiment. FIG. 4 may be described with reference to the previously described embodiment.

Referring to FIG. 4, an embodiment in which the electronic device 100 identifies the charging-related information (for example, at least one piece of the information on the cable 191 connected to the connector 110 (for example, information on the type of the cable 191 or the maximum allowable current supported by the cable 191 (for example, impedance information or authentication information)), the information on the power (for example, suppliable voltage and current) supported by the power source 190, or the information on the charging power (for example, charging voltage and charging current or input voltage and input current) for charging the battery 130).

At least some of the operations in FIG. 4 may be omitted. The order of the operations in FIG. 4 may be changed. Operations other than the operations of FIG. 4 may be performed before, during, or after the operations of FIG. 4.

Referring to FIG. 4, in operation 401, according to an embodiment, the electronic device 100 (for example, the controller 150) may identify impedance of the cable 191 connected to the connector 110 through the PDIC 160. For example, the PDIC 160 may identify impedance of the cable 191 connected to the connector 110. For example, the PDIC 160 may inject a signal into CC1/CC2 or DP/DN of the cable 191. The PDIC 160 may identify impedance of the cable 191, based on the signal injected into CC1/CC2 or DP/DN of the cable 191. In another example, the PDIC 160 may exchange authentication information with the cable 191 and identify a characteristic (for example, impedance) of the cable 191, based on the authentication information.

In operation 403, according to an embodiment, the electronic device 100 (for example, the controller 150) may control the PDIC 160 to provide a signal for information related to the impedance identified in operation 401 to the controller 150. For example, the PDIC 160 may provide the signal for the impedance identified in operation 401 to the controller 150.

In operation 405, according to an embodiment, the electronic device 100 (for example, the controller 150) may identify the charging-related information, based on the signal provided from the PDIC 160. For example, the electronic device 100 (for example, the controller 150) may identify the charging-related information (for example, at least one piece of the information on the cable 191 connected to the connector 110 (for example, information on the type of the cable 191 or the maximum allowable current supported by the cable 191 (for example, impedance information or authentication information)), the information on the power (for example, suppliable voltage and current) supported by the power source 190, or the information on the charging power (for example, charging voltage and charging current or input voltage and input current) for charging the battery 130). For example, the electronic device 100 (for example, the controller 150) may identify the maximum allowable current corresponding to the impedance of the cable 191, based on a rating table. The "rating table" may include information on the impedance of the cable 191 and the allowable current matching the impedance.

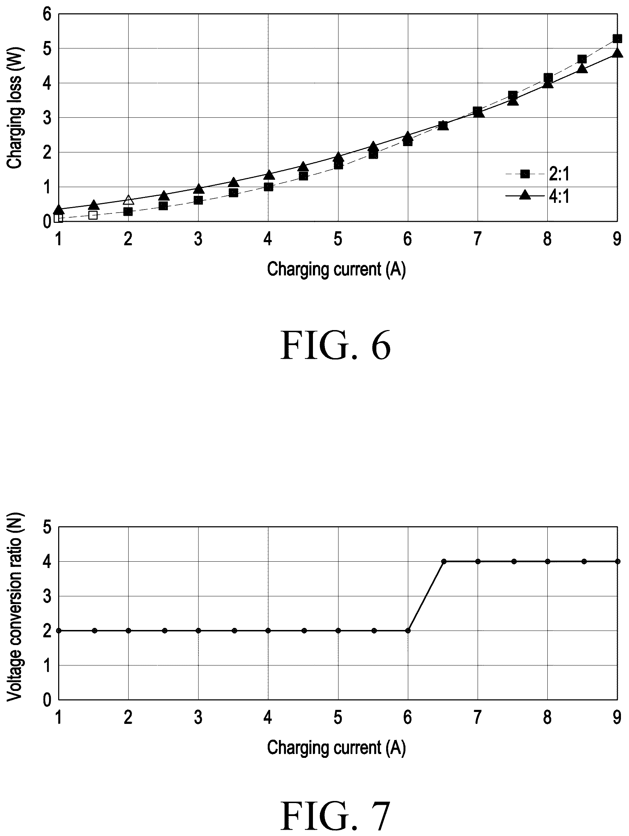

FIG. 5 is a flowchart illustrating a method of operating the electronic device according to an embodiment. FIG. 5 may be described with reference to the previously described embodiment, FIG. 6, and FIG. 7. FIG. 6 is a diagram illustrating an operation of the electronic device according to an embodiment. FIG. 7 is a diagram illustrating an operation of the electronic device according to an embodiment.

An embodiment in which the electronic device 100 identifies a voltage conversion ratio, based on charging-related information, may be understood with reference to FIGS. 5, 6, and 7.

At least some of the operations in FIG. 5 may be omitted. The order of the operations in FIG. 5 may be changed. Operations other than the operations of FIG. 5 may be performed before, during, or after the operations of FIG. 5.

Referring to FIG. 5, in operation 501, according to an embodiment, the electronic device 100 (for example, the controller 150) may identify charging-related information (for example, at least one piece of information on the cable 191 connected to the connector 110 (for example, information on the type of the cable 191 or the maximum allowable current supported by the cable 191), information on maximum power (for example, input voltage and input current) supported by the power source 190, or information on charging power (for example, charging voltage and charging current) for charging the battery 130). Operation 501 may correspond to operation 201 of FIG. 2, operation 307 of FIG. 3, or operation 405 of FIG. 4.

In operation 503, according to an embodiment, the electronic device 100 (for example, the controller 150) may identify the charging current of the battery 130. The electronic device 100 may identify the charging current required for charging the battery 130, based on information related to charging before the charging of the battery 130 starts. The electronic device 100 may identify the charging current provided to the battery 130 while the battery 130 is charged. The electronic device 100 may identify a second charging current required for charging the battery 130, based on charging-related information while the battery 130 is changed by a first charging current. "The current first charging current" and "the required second charging current" may be different in which case the electronic device 100 may identify that the charging current needs to be changed. "The current first charging current" and "the required second charging current" may be the same in which case the electronic device 100 may identify that the charging current needs to be maintained.

In operation 505, according to an embodiment, the electronic device 100 (for example, the controller 150) may identify charging loss of the electronic device 100, based on the charging current of the battery 130. The "charging loss" may be loss generated in the electronic device 100 while the battery 130 is charged based on the first charging current. For example, the charging loss may include loss generated in the connector 110 by power provided by the power source 190. For example, the charging loss may include loss (conduction loss by the input current) generated by wiring resistance (for example, 111 of FIG. 1) from the connector 110 to the charging circuit 120 by power provided from the power source 190. For example, the charging loss may include loss generated when power is converted in the charging circuit 120 according to the efficiency of the charging circuit 120. The electronic device 100 may identify the input current (for example, an input current provided from the power source 190 to the electronic device 100, an input current required to be provided from the power source 190 to the electronic device 100, and/or an input current required to be provided to the charging circuit 120), based on the charging current of the battery 130 (for example, a charging current currently provided to the battery 130 and/or a charging current required to be provided to the battery 130), and identify charging loss of the electronic device 100 (for example, charging loss currently generated in the electronic device 100 and/or charging loss expected to be generated in the electronic device 100), based on the identified charging current and the identified input current. FIG. 6 is a graph illustrating the charging current and the charging loss according to the voltage conversion ratio. For example, referring to FIG. 6, the relation between the charging current and the charging loss may be identified in the case where the voltage conversion ratio N1 is 2 (for example, 2:1) and the voltage conversion ration N2 is 4 (for example, 4:1). The electronic device 100 may identify the charging current (for example, the current charging current and/or the required charging current) and identify the charging loss corresponding to the identified charging current. FIG. 6 is only an example, and the relation between the charging current and the charging loss is not limited to FIG. 6. For example, FIG. 6 is a graph illustrating two voltage conversion ratios, but there is no limitation on the number of voltage conversion ratios which the charging circuit 120 can provide. The electronic device 100 may identify the relation between the charging current and the charging loss according to a plurality of voltage conversion ratios.

In operation 507, according to an embodiment, the electronic device 100 (for example, the controller 150) may identify a voltage conversion ratio of the charging circuit 120, based on charging loss of the electronic device 100. For example, the electronic device 100 may identify the voltage conversion ration of the charging circuit 120, based on charging-related information to reduce the charging loss or to make the charging loss minimum. The electronic device 100 may identify the charging current (For example, the current charging current and/or the required charging current) and identify (for example, select or determine) the voltage conversion ratio to reduce the charging loss corresponding to the identified charging current or make the charging loss minimum. For example, referring to FIG. 6, in the case where the selectable voltage conversion ratio is 2 or 4, the electronic device 100 identifies the charging current (for example, the current charging current and/or the required charging current) as 6 [A] and thus may identify (for example, select or determine) the voltage conversion ratio of the charging circuit 120 as 2 to reduce the charging loss or make the charging loss minimum. For example, referring to FIG. 7, the electronic device 100 may identify (for example, select or determine) the voltage conversion ratio according to a range of the identified charging current (for example, the current charging current and/or the required charging current). For example, in FIGS. 6 and 7, in the case where the selectable voltage conversion ratio is 2 or 4, the charging loss is smaller when the voltage conversion ratio is 2 if the charging current is lower than (or equal to or lower than) 6.5 [A], and the charging loss is smaller when the voltage conversion ratio is 4 if the charging current is higher (or higher than or equal to) 6.5 [A]. In this case, the electronic device 100 may identify (for example, select or determine) the voltage conversion ratio as 2 when the identified charging current (for example, the current charging current and/or the required charging current) is lower (or equal to lower than) 6.5 [A] and may identify (for example, select or determine) the voltage conversion ratio as 4 when the identified charging current (for example, the current charging current and/or the required charging current) is higher (or higher than or equal to) 6.5 [A]. The electronic device 100 may identify the voltage conversion ratio in consideration of the charging loss as described above, or may identify the voltage conversion ratio in consideration of both the allowable current of the cable 191 in the charging-related information and the charging loss.

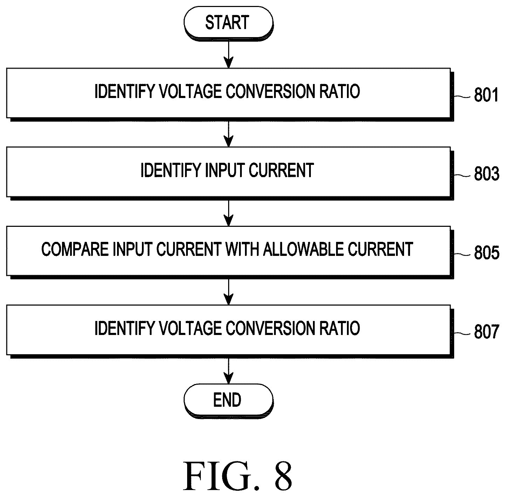

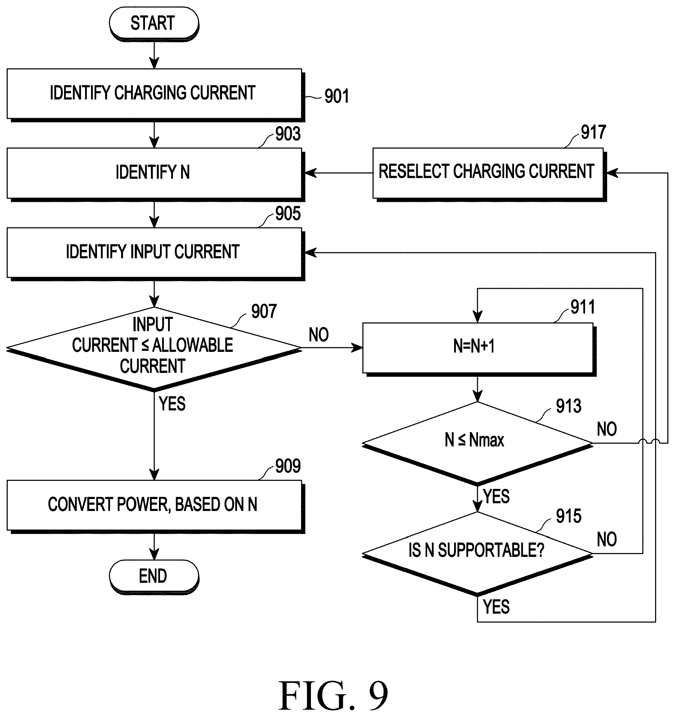

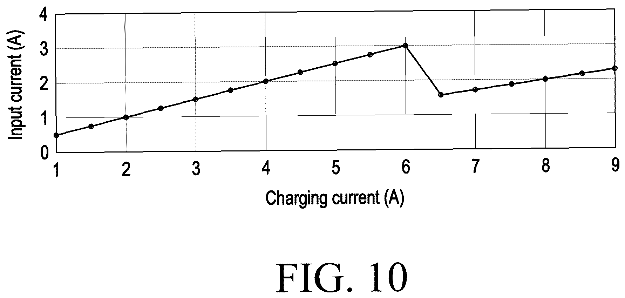

FIG. 8 is a flowchart illustrating a method of operating the electronic device according to an embodiment. FIG. 8 may be described with reference to the previously described embodiment, FIG. 9, and FIG. 10. FIG. 9 is a flowchart illustrating a method of operating the electronic device according to an embodiment. FIG. 10 is a diagram illustrating an operation of the electronic device according to an embodiment.

An embodiment in which the electronic device 100 identifies a voltage conversion ratio, based on charging-related information, may be understood with reference to FIGS. 8, 9, and 10.

At least some of the operations in FIG. 8 may be omitted. The order of the operations in FIG. 8 may be changed. Operations other than the operations of FIG. 8 may be performed before, during, or after the operations of FIG. 8.

Referring to FIG. 8, in operation 801, according to an embodiment, the electronic device 100 (for example, the controller 150) may identify the voltage conversion ratio of the charging circuit 120. Operation 801 may correspond to operation 507 of FIG. 5. Based on the charging-related information, the electronic device 100 may identify the charging current (for example, a charging current currently provided to the battery 130 and/or a charging current required to be provided to the battery 130) and select the voltage conversion ratio, based on charging loss corresponding to the charging current.

In operation 803, according to an embodiment, the electronic device 100 (for example, the controller 150) may identify an input current corresponding to the charging current. For example, the input current may be determined according to the charging current and the voltage conversion ratio, and the electronic device 100 may make a request for providing power to the power source 190, based on the determined input current. Before making the request for providing power (or changing power) to the power source 190, the electronic device 100 may identify the input current (for example, expected input current) corresponding to the charging current. The "expected input current" may be a current required to be provided from the power source 190 to the electronic device 100 or a current required to be input into the charging circuit 120 in order to satisfy the identified charging current.

In operation 805, according to an embodiment, the electronic device 100 (for example, the controller 150) may compare the input current (for example, expected input current) identified in operation 803 with the allowable current (for example, the maximum allowable current of the cable 191). The electronic device 100 may identify the input current (for example, expected input current) corresponding to the charging current of the battery 130, identify the maximum allowable current of the cable 191, based on charging-related information, and compare the input current (for example, expected input current) with the allowable current.

In operation 807, according to an embodiment, the electronic device 100 (for example, the controller 150) may identify (for example, select or change) the voltage conversion ratio according to the result of comparison between the input current (for example, expected input current) and the allowable current.

The embodiment of the operation of FIG. 8 is described with reference to FIG. 9.

At least some of the operations in FIG. 9 may be omitted. The order of the operations in FIG. 9 may be changed. Operations other than the operations of FIG. 9 may be performed before, during, or after the operations of FIG. 9.

The operation of FIG. 9 may be performed to change (or maintain) the voltage conversion ratio of the charging circuit 120 while the battery 130 of the electronic device 100 is charged or may be performed to determine (or configure) the voltage conversion ratio of the charging circuit 120 before the battery 130 of the electronic device 100 is charged.

Referring to FIG. 9, in operation 901, according to an embodiment, the electronic device 100 (for example, the controller 150) may identify the charging current of the battery 130. Operation 901 may correspond to operation 503 of FIG. 5.

In operation 903, according to an embodiment, the electronic device 100 (for example, the controller 150) may identify the voltage conversion ratio (for example, N) of the charging circuit 120, based on charging loss of the electronic device 100 corresponding to the charging current of the battery 130. Operation 901 to operation 903 may correspond to operation 503, operation 505, and operation 507 of FIG. 5.

In operation 905, according to an embodiment, the electronic device 100 (for example, the controller 150) may identify an input current corresponding to the charging current. Operation 905 may correspond to operation 803 of FIG. 8.

In operation 907, according to an embodiment, the electronic device 100 (for example, the controller 150) may compare the input current (for example, expected input current) identified in operation 905 with the allowable current (for example, the maximum allowable current of the cable 191). Operation 907 may correspond to operation 805 of FIG. 8.

In operation 909, according to an embodiment, based on the input current (for example, expected input current) being equal to or lower than the allowable current (for example, maximum allowable current of the cable 191), the electronic device 100 (for example, the controller 150) may convert power by using the charging circuit 120, based on the voltage conversion ratio identified in operation 903. The electronic device 100 may control the charging circuit 120, based on the identified voltage conversion ratio. According to an embodiment, based on the input current (for example, expected input current) being equal to or lower than the allowable current (for example, maximum allowable current of the cable 191), the electronic device 100 (for example, the controller 150) may make a request for power corresponding to the input current (for example, expected input current) to the power source 190.

In operation 911, according to an embodiment, based on the input current (for example, expected input current) being higher than the allowable current (for example, maximum allowable current of the cable 191), the electronic device 100 (for example, the controller 150) may identify a new voltage conversion ratio (for example, N+1) instead of the voltage conversion ratio (for example, N) identified in operation 903. The new voltage conversion ratio of N+1 in FIG. 9 is an example, and there is no limitation on a method of identifying a new voltage conversion ratio. For example, the new voltage conversion ratio may be N+2 or 2*N.

In operation 913, according to an embodiment, the electronic device 100 (for example, the controller 150) may compare the voltage conversion ratio identified in operation 911 with a maximum voltage conversion ratio. The "maximum voltage conversion ratio" may be a maximum value among voltage conversion ratios which the charging circuit 120 can provide.

In operation 915, according to an embodiment, the electronic device 100 (for example, the controller 150) may identify whether the voltage conversion ratio identified in operation 911 is a voltage conversion ratio supportably by the charging circuit 120, based on the voltage conversion ratio identified in operation 911 being equal to or smaller than the maximum voltage conversion ratio. Referring to FIGS. 11, 12, 13, and 14, the voltage conversion ratio supportable by the charging circuit 120 may vary depending on the design of the charging circuit 120. Accordingly, even through the voltage conversion ratio identified in operation 911 is equal to or smaller than the maximum voltage conversion, the electronic device 100 may additionally identify whether the voltage conversion ratio identified in operation 911 is the voltage conversion ratio supportable by the charging circuit 120. Alternatively, it may be understood by those skilled in the art that operation 915 may be performed before operation 913. For example, the electronic device 100 may select a new voltage conversion ratio from among the voltage conversion ratios supportable by the charging circuit 120 during the process of operation 911. The electronic device 100 may perform operation 905, based on the new voltage conversion ratio selected in operation 911 according to the new voltage conversion ratio selected in operation 911 satisfies the condition of operation 913 and the condition of operation 915. As the voltage conversion ratio identified in operation 911 is not the voltage conversion ratio supportable by the charging circuit 120, the electronic device 100 may perform again operation 911.

In operation 917, according to an embodiment, the electronic device 100 (for example, the controller 150) may reselect the charging current of the battery 130, based on the voltage conversion ratio identified in operation 911 being larger than the maximum voltage conversion ratio. Based on the voltage conversion ratio identified in operation 911 being larger than the maximum voltage conversion ratio, the electronic device 100 may reselect the charging current of the battery 130, based on charging-related information.

Referring to FIGS. 9 and 10, according to an embodiment, the electronic device 100 may identify the voltage conversion ratio of the charging circuit 120, based on charging loss corresponding to the charging current required by the battery 130. As the charging current required by the battery 130 increases within, for example, a range equal to or smaller than 6 [A] while the battery 130 is charged according to the identified voltage conversion ratio, the electronic device 100 may make a request for increasing the input current to the power source 190. The electronic device 100 may change the voltage conversion ratio of the charging circuit 120 before the input current exceeds the allowable current by comparing the expected input current corresponding to the charging current with the allowable current of the cable 191 while the input current increases. For example, in FIG. 10, an embodiment in which the operation is performed while the voltage conversion ratio is 2 when the charging current is lower than or equal to 6 [A] and the voltage conversion ratio is changed from 2 to 4 as the charging current exceeds 6 [A] may be identified.

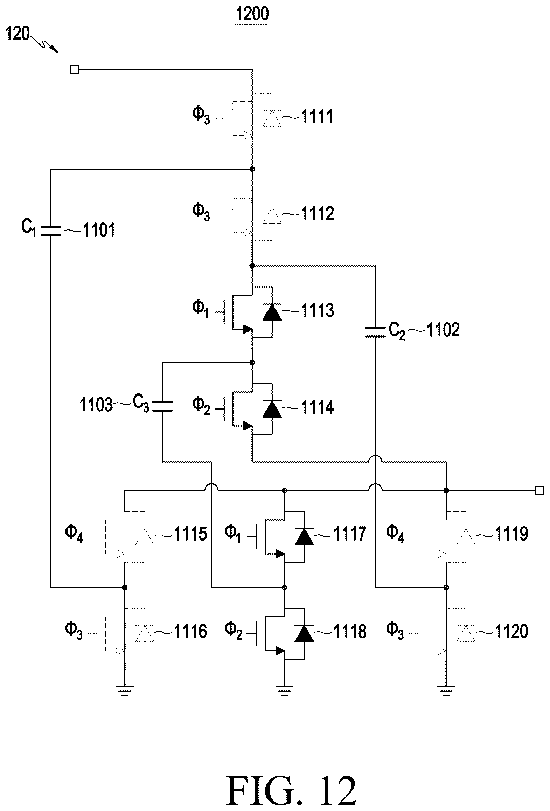

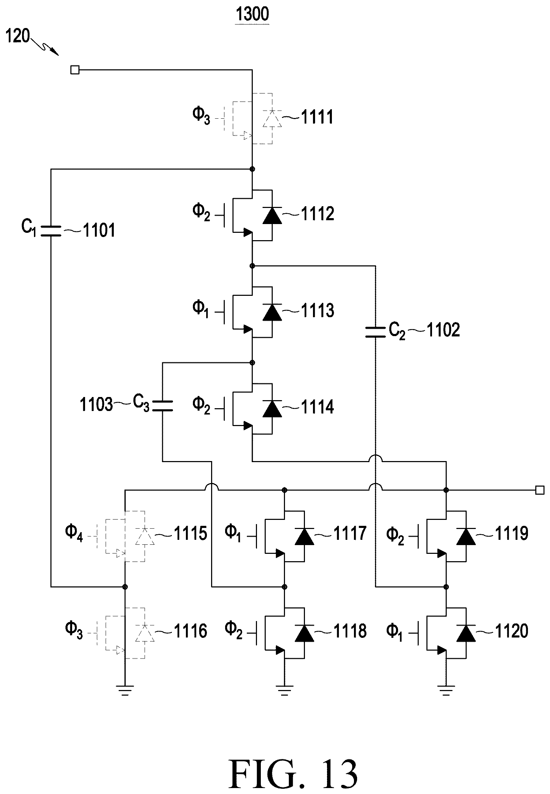

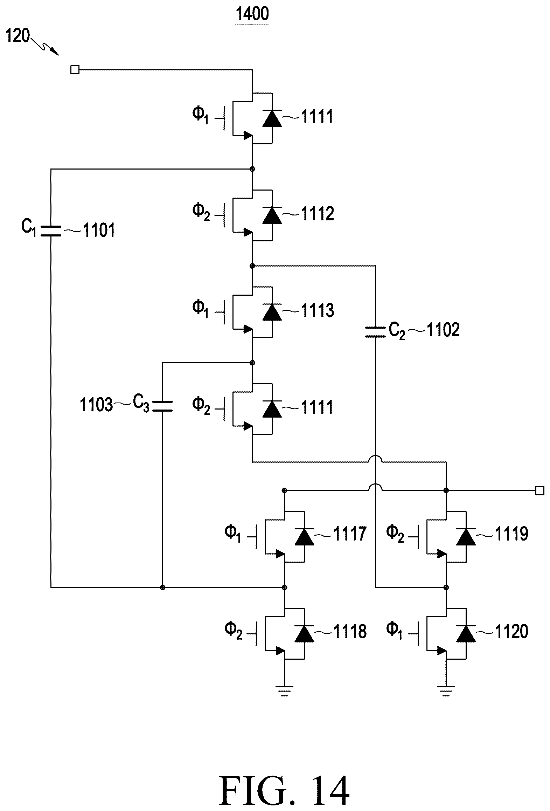

FIG. 11 is a circuit diagram illustrating the charging circuit of the electronic device according to an embodiment. FIG. 12 is a circuit diagram illustrating the charging circuit of the electronic device according to an embodiment. FIG. 13 is a circuit diagram illustrating the charging circuit of the electronic device according to an embodiment. FIG. 14 is a circuit diagram illustrating the charging circuit of the electronic device according to an embodiment.

Referring to FIGS. 11, 12, 13, and 14, the operation in which the electronic device 100 controls the voltage conversion ratio of the charging circuit 120 may be understood.

Referring to a circuit diagram 1100 of FIG. 11, the charging circuit 120 may include a plurality of switches 1111, 1112, 1113, 1114, 1115, 1116, 1117, 1118, 1119, and 1120, and a plurality of capacitors 1101, 1102, and 1103. An input current (for example, $v_1$ and $i_1$ of FIG. 1) may be input into a first terminal of the first switch 1111. A second terminal of the first switch 1111 may be electrically connected to a first terminal of the second switch 1112. A second terminal of the second switch 1112 may be electrically connected to a first terminal of the third switch 1113. A second terminal of the third switch 1113 may be electrically connected to a first terminal of the fourth switch 1114. A second terminal of the fourth switch 1114 may be electrically connected to a first terminal of the fifth switch 1115. A second terminal of the fifth switch 1115 may be electrically connected to a first terminal of the sixth switch 1116. A second terminal of the sixth switch 1115 may be electrically connected to the ground terminal. A second terminal of the fourth switch 1114 may be electrically connected to a first terminal of the seventh switch 1117. A second terminal of the seventh switch 1117 may be electrically connected to a first terminal of the eighth switch 1118. A second terminal of the eighth switch 1118 may be electrically connected to the ground terminal. The second terminal of the fourth switch 1114 may be electrically connected to a first terminal of the ninth switch 1119. A second terminal of the ninth switch 1119 may be electrically connected to a first terminal of the tenth switch 1120. A second terminal of the tenth switch 1120 may be electrically connected to the ground terminal. A first terminal of the first capacitor 1101 may be electrically connected to the second terminal of the first switch 1111. A second terminal of the first capacitor 1101 may be electrically connected to the second terminal of the fifth switch 1115. A first terminal of the second capacitor 1102 may be electrically connected to the second terminal of the second switch 1112. A second terminal of the second capacitor 1102 may be electrically connected to the second terminal of the ninth switch 1119. A first terminal of the third capacitor 1103 may be electrically connected to the second terminal of the third switch 1113. A second terminal of the third capacitor 1102 may be electrically connected to the second terminal of the seventh switch 1117. The first terminal of the ninth switch 1119 may be an output terminal of the charging circuit 120.

Referring to FIGS. 11, 12, and 13, in the charging circuit 120, it may be understood that the voltage conversion ratio of the charging circuit 120 is changed according to the operation of the plurality of switches 1111, 1112, 1113, 1114, 1115, 1116, 1117, 1118, 1119, and 1120.

Referring to the circuit diagram 1100 of FIG. 11, the electronic device 100 (for example, the controller 150) may control the voltage conversion ratio of the charging circuit 120 to 4 by alternately controlling on/off of switches of a first group (for example, the first switch 1111, the third switch 1113, the fifth switch 1115, the seventh switch 1117, and the tenth switch 1120) represented by $\varphi_1$ and switches of a second group (for example, the second switch 1112, the fourth switch 1114, the sixth switch 1116, the eighth switch 1118, and the ninth switch 1119) represented by $\varphi_2$. Accordingly, the output voltage (for example, $V_O$) of the charging circuit 120 may be 1/4 of the input voltage (for example, $V_{IN}$), and the output current of the charging circuit 120 may be four times the input current.

Referring to a circuit diagram 1200 of FIG. 12, the electronic device 100 (for example, the controller 150) may alternately control on/off of switches of a first group (for example, the third switch 1113 and the seventh switch 1117) represented by $\varphi_1$ and switches of a second group (for example, the fourth switch 1114 and the eighth switch 1118) represented by $\varphi_2$, control switches of a third group (for example, the first switch 1111, the second switch 1112, the sixth switch 1116, and the tenth switch 1120) represented by $\varphi_3$ to on, and control switches of a fourth group (for example, the fifth switch 1115 and the ninth switch 1119) represented by $\varphi_4$ to off, so as to control the voltage conversion ratio of the charging circuit 120 to 2. Accordingly, the output voltage (for example, $V_O$) of the charging circuit 120 may be 1/2 of the input voltage (for example, $V_{IN}$), and the output current of the charging circuit 120 may be two times the input current.

Referring to a circuit diagram 1300 of FIG. 13, the electronic device 100 (for example, the controller 150) may control the voltage conversion ratio of the charging circuit 120 to 3 by alternately controlling on/off of switches of a first group (for example, the third switch 1113, the seventh switch 1117, and the tenth switch 1120) represented by $\varphi_1$, switches of a second group (for example, the second switch 1112, the fourth switch 1114, the eighth switch 1118, and the ninth switch 1119) represented by $\varphi_2$, and switches of a third group (for example, the first switch 1111 and the sixth switch 1115) represented by $\varphi_3$, and controlling a switch of a fourth group (for example, the fifth switch 1115) represented by $\varphi_4$. Accordingly, the output voltage (for example, $V_O$) of the charging circuit 120 may be 1/3 of the input voltage (for example, $V_{IN}$), and the output current of the charging circuit 120 may be three times the input current.

Accordingly, the charging circuit 120 of FIGS. 11, 12, and 13 may provide a plurality of voltage conversion ratios (for example, 2, 3, and 4).

When the charging circuit 120 is configured as shown in a circuit diagram 1400 of FIG. 14, the charging circuit 120 may provide a voltage conversion ratio of 4:1 or 2:1.

Therefore, according to the configuration of the charging circuit 120, a maximum voltage conversion ratio of the charging circuit 120 and a voltage conversion ratio supportable by the charging circuit 120 may be determined.

It may be understood by those skilled in the art that embodiments described in this specification can be mutually and organically applied within an applicable range. For example, it may be understood by those skilled in the art that at least some operations of an embodiment described in this specification can be omitted and applied, and at least some operations of an embodiment and at least some operations of another embodiment can be organically combined and applied.

According to an embodiment, the electronic device 100 may include the connector 110 for a connection with the external power source 190, the charging circuit 120 configured to convert power provided through the connector 110, the battery 130 configured to receive power through the charging circuit 120, and the controller 150 operatively and/or electrically connected to the charging circuit 120. The controller 150 may be configured to identify charging-related information. The controller 150 may be configured to identify a first voltage conversion ratio of the charging circuit 120, based on the charging-related information. The controller 150 may be configured to control the charging circuit 120 to convert power provided through the connector 110, based on the first voltage conversion ratio. The controller 150 may be configured to identify a second voltage conversion ratio different from the first voltage conversion ratio of the charging circuit 120, based on the charging-related information while the battery 130 is charged based on the first voltage conversion ratio. The controller 150 may be configured to control the charging circuit 120 to convert power provided through the connector 110, based on the second voltage conversion ratio.

According to an embodiment, the charging-related information may include at least one piece of information on an allowable current of the cable 191 connected to the connector 110 or information on an input current from the power source 190 to the electronic device 100.

According to an embodiment, the controller 150 may be configured to identify a charging current for charging the battery 130, based on the charging-related information. The controller 150 may be configured to identify a charging loss of the electronic device 100, based on the charging current. The controller 150 may be configured to identify the first voltage conversion ratio or the second voltage conversion ratio, based on the charging loss.

According to an embodiment, the controller 150 may be configured to identify an expected input current to be provided from the power source 190, based on the charging current while the battery 130 is charged based on the first voltage conversion ratio. The controller 150 may be configured to determine to change the voltage conversion ratio of the charging circuit 120 from the first voltage conversion ratio to the second voltage conversion ratio by comparing the expected input current to be provided from the power source 190 with the allowable current of the cable 191.

According to an embodiment, the controller 150 may be configured to identify the second voltage conversion ratio as the expected input current to be provided from the power source 190 exceeds the allowable current. The controller 150 may be configured to, based on the second voltage conversion ratio being equal to or smaller than a maximum voltage conversion ratio, perform at least one operation according to the second voltage conversion ratio. The controller 150 may be configured to, based on the second voltage conversion ratio being equal to or smaller than the maximum voltage conversion ratio, identify whether the second voltage conversion ratio is supportable by the charging circuit 120. The controller 150 may be configured to, based on the second voltage conversion ratio being equal to or smaller than the maximum voltage conversion ratio, identify an input current (for example, $i_1$ of FIG. 1), based on the second voltage conversion ratio. The controller 150 may be configured to, based on the second voltage conversion ratio being equal to or smaller than the maximum voltage conversion ratio, control the charging circuit 120 to convert power, based on the second voltage conversion ratio.

According to an embodiment, the controller 150 may be configured to, based on the second voltage conversion ratio being larger than the maximum voltage conversion ratio, reselect the charging current.

According to an embodiment, the controller 150 may be configured to identify the charging-related information, based on communication with the power source 190.

According to an embodiment, the electronic device 100 may include the power delivery integrated circuit (PDIC) 160 operatively and/or electrically connected to the connector 110 and the controller 150. The PDIC 160 may be configured to identify the charging-related information through universal serial bus (USB) power delivery (PD) communication with the power source 190. The PDIC 160 may be configured to provide a first signal for the identified charging-related information to the controller 150. The controller 150 may be configured to identify the charging-related information, based on the first signal.

According to an embodiment, the controller 150 may be configured to identify the charging-related information, based on impedance of the cable 191 connected to the connector 110.

According to an embodiment, the electronic device 100 may include the power delivery integrated circuit (PDIC) 160 operatively and/or electrically connected to the connector 110 and the controller 150. The PDIC 160 may be configured to identify the impedance of the cable 191 connected to the connector 110. The PDIC 160 may be configured to provide a second signal for the impedance of the cable 191 to the controller 150. The controller 150 may be configured to identify the charging-related information, based on the second signal.

According to an embodiment, a method of operating the electronic device 100 may include an operation of identifying charging-related information. The method may include an operation of identifying a first voltage conversion ratio of the charging circuit 120 of the electronic device 100, based on the charging-related information. The method may include an operation of controlling the charging circuit 120 to convert power provided through a connector 110 of the electronic device 100 for a connection with an external power source 190, based on the first voltage conversion ratio. The method may include an operation of identifying a second voltage conversion ratio different from the first voltage conversion ratio of the charging circuit 120 while the battery 130 of the electronic device 100 is charged based on the first voltage conversion ratio. The method may include an operation of controlling the charging circuit 120 to convert power provided through the connector 110, based on the second voltage conversion ratio.

According to an embodiment, the charging-related information may include at least one piece of information on an allowable current of the cable 191 connected to the connector 110 or information on an input current from the power source 190 to the electronic device 100.

According to an embodiment, the operation of identifying the first voltage conversion ratio or the operation of identifying the second voltage conversion ratio may include an operation of identifying identify a charging current for charging the battery 130, based on the charging-related information. The operation of identifying the first voltage conversion ratio or the operation of identifying the second voltage conversion ratio may include an operation of identifying a charging loss of the electronic device 100, based on the charging current. The operation of identifying the first voltage conversion ratio or the operation of identifying the second voltage conversion ratio may include an operation of identifying the first voltage conversion ratio or the second voltage conversion ratio, based on the charging loss.

According to an embodiment, the operation of identifying the second voltage conversion ratio may include an operation of identifying an expected input current to be provided from the power source 190, based on the charging current while the battery 130 is charged based on the first voltage conversion ratio. The operation of identifying the second voltage conversion ratio may include an operation of determining to change the voltage conversion ratio of the charging circuit 120 from the first voltage conversion ratio to the second voltage conversion ratio by comparing the expected input current to be provided from the power source 190 with the allowable current of the cable 191.

According to an embodiment, the operation of identifying the second voltage conversion ratio may include an operation of identifying the second voltage conversion ratio as the expected input current to be provided from the power source 190 exceeds the allowable current. The operation of identifying the second voltage conversion ratio may include an operation of, based on the second voltage conversion ratio being equal to or smaller than a maximum voltage conversion ratio, performing at least one operation according to the second voltage conversion ratio. The at least one operation may include an operation of identifying whether the second voltage conversion ratio is supportable by the charging circuit 120, based on the second voltage conversion ratio being equal to or smaller than the maximum voltage conversion ratio. The at least one operation may include an operation of, based on the second voltage conversion ratio being equal to or smaller than the maximum voltage conversion ratio, identifying an input current (for example, $i_1$ of FIG. 1), based on the second voltage conversion ratio. The at least one operation may include an operation of, based on the second voltage conversion ratio being equal to or smaller than the maximum voltage conversion ratio, controlling the charging circuit 120 to convert power, based on the second voltage conversion ratio.

According to an embodiment, the operation of identifying the second voltage conversion ratio may include an operation of reselecting the charging current as the second voltage conversion ratio exceeds the maximum voltage conversion ratio.

According to an embodiment, the operation of identifying the charging-related information may include an operation of identifying the charging-related information, based on communication with the power source 190.

According to an embodiment, the operation of identifying the charging-related information may include an operation of identifying the charging-related information through universal serial bus (USB) power delivery (PD) communication with the power source 190 by the power delivery integrated circuit (PDIC) 160 of the electronic device 100. The operation of identifying the charging-related information may include an operation of providing a first signal for the identified charging-related information to the controller 150. The operation of identifying the charging-related information may include an operation of identifying the charging-related information, based on the first signal, by the controller 150.

According to an embodiment, the operation of identifying the charging-related information may include an operation of identifying the charging-related information, based on impedance of the cable 191 connected to the connector 110.

According to an embodiment, the operation of identifying the charging-related information may include

An operation of identifying the impedance of the cable 190 connected to the connector 110 by the power delivery integrated circuit (PDIC) 160 of the electronic device 100. The operation of identifying the charging-related information may include an operation of providing a second signal for the impedance of the cable 191 to the controller 150 by the PDIC 160. The operation of identifying the charging-related information may include an operation of identifying the charging-related information, based on the second signal by the controller 150.

According to an embodiment, a computer-readable recording medium storing instructions configured to cause the controller 150 of the electronic device 100 to perform at least one operation may be provided. The at least one operation may include an operation of identifying charging-related information. The at least one operation may include an operation of identifying a first voltage conversion ratio of the charging circuit 120 of the electronic device 100, based on the charging-related information. The at least one operation may include an operation of controlling the charging circuit 120 to convert power provided through the connector 110 of the electronic device 100 for a connection with the external power source 190, based on the first voltage conversion ratio. The at least one operation may include an operation of identifying a second voltage conversion ratio different from the first voltage conversion ratio of the charging circuit 120 while the battery 130 of the electronic device 100 is charged based on the first voltage conversion ratio. The at least one operation may include an operation of controlling the charging circuit 120 to convert power provided through the connector 110, based on the second voltage conversion ratio.

According to an embodiment, the charging-related information may include at least one piece of information on an allowable current of the cable 191 connected to the connector 110 or information on an input current from the power source 190 to the electronic device 100.

According to an embodiment, the operation of identifying the first voltage conversion ratio or the operation of identifying the second voltage conversion ratio may include an operation of identifying identify a charging current for charging the battery 130, based on the charging-related information. The operation of identifying the first voltage conversion ratio or the operation of identifying the second voltage conversion ratio may include an operation of identifying a charging loss of the electronic device 100, based on the charging current. The operation of identifying the first voltage conversion ratio or the operation of identifying the second voltage conversion ratio may include an operation of identifying the first voltage conversion ratio or the second voltage conversion ratio, based on the charging loss.

According to an embodiment, the operation of identifying the second voltage conversion ratio may include an operation of identifying an expected input current to be provided from the power source 190, based on the charging current while the battery 130 is charged based on the first voltage conversion ratio. The operation of identifying the second voltage conversion ratio may include an operation of determining to change the voltage conversion ratio of the charging circuit 120 from the first voltage conversion ratio to the second voltage conversion ratio by comparing the expected input current to be provided from the power source 190 with the allowable current of the cable 191.

According to an embodiment, the operation of identifying the second voltage conversion ratio may include an operation of identifying the second voltage conversion ratio as the expected input current to be provided from the power source 190 exceeds the allowable current. The operation of identifying the second voltage conversion ratio may include an operation of, based on the second voltage conversion ratio being equal to or smaller than a maximum voltage conversion ratio, performing at least one operation according to the second voltage conversion ratio. The at least one operation may include an operation of identifying whether the second voltage conversion ratio is supportable by the charging circuit 120, based on the second voltage conversion ratio being equal to or smaller than the maximum voltage conversion ratio. The at least one operation may include an operation of, based on the second voltage conversion ratio being equal to or smaller than the maximum voltage conversion ratio, identifying an input current (for example, $i_1$ of FIG. 1), based on the second voltage conversion ratio. The at least one operation may include an operation of, based on the second voltage conversion ratio being equal to or smaller than the maximum voltage conversion ratio, controlling the charging circuit 120 to convert power, based on the second voltage conversion ratio.

According to an embodiment, the operation of identifying the second voltage conversion ratio may include an operation of reselecting the charging current as the second voltage conversion ratio exceeds the maximum voltage conversion ratio.

According to an embodiment, the operation of identifying the charging-related information may include an operation of identifying the charging-related information, based on communication with the power source 190.

According to an embodiment, the operation of identifying the charging-related information may include an operation of identifying the charging-related information through universal serial bus (USB) power delivery (PD) communication with the power source 190 by the power delivery integrated circuit (PDIC) 160 of the electronic device 100. The operation of identifying the charging-related information may include an operation of providing a first signal for the identified charging-related information from the PDIC 160 to the controller 150 of the electronic device 100. The operation of identifying the charging-related information may include an operation of identifying the charging-related information, based on the first signal, by the controller 150.

According to an embodiment, the operation of identifying the charging-related information may include an operation of identifying the charging-related information, based on impedance of the cable 191 connected to the connector 110.

According to an embodiment, the operation of identifying the charging-related information may include

An operation of identifying the impedance of the cable 190 connected to the connector 110 by the power delivery integrated circuit (PDIC) 160 of the electronic device 100. The operation of identifying the charging-related information may include an operation of providing a second signal for the impedance of the cable 191 to the controller 150 by the PDIC 160. The operation of identifying the charging-related information may include an operation of identifying the charging-related information, based on the second signal by the controller 150.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software including one or more instructions that are stored in a storage medium (e.g., internal memory or external memory) that is readable by a machine. For example, a processor (e.g., the controller) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore™), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:

   a connector for connecting with an external power source;
   a charging circuit configured to convert power provided through the connector;
   a battery configured to receive power through the charging circuit; and
   a controller operatively and/or electrically connected to the charging circuit,
   wherein the controller is configured to:

   identify information related to charging,
   based on the information related to the charging, identify a first voltage conversion ratio of the charging circuit,
   based on the first voltage conversion ratio, control the charging circuit to convert power provided through the connector,
   while the battery is being charged based on the first voltage conversion ratio, identify, based on the information related to the charging, a second voltage conversion ratio different from the first voltage conversion ratio of the charging circuit, and

based on the second voltage conversion ratio, control the charging circuit to convert power provided through the connector.

2. The electronic device of claim 1, wherein the information related to the charging includes at least one of information on an allowable current of a cable connected to the connector or information on an input current from the power source to the electronic device.

3. The electronic device of claim 2 or 3, wherein the controller is configured to:

   based on the information related to the charging, identify a charging current for charging the battery,
   based on the charging current, identify a charging loss of the electronic device, and
   based on the charging loss, identify the first voltage conversion ratio or the second voltage conversion ratio.

4. The electronic device of any one of claims 1 to 3, wherein the controller is configured to:

   based on the charging current, identify an expected input current to be provided from the power source, while the battery is being charged based on the first voltage conversion ratio, and
   determine to change a voltage conversion ratio of the charging circuit from the first voltage conversion ratio to the second voltage conversion ratio by comparing the expected input current to be provided from the power source with the allowable current of the cable.

5. The electronic device of any one of claims 1 to 4, wherein the controller is configured to:

   identify the second voltage conversion ratio as the expected input current to be provided from the power source exceeds the allowable current, and
   based on the second voltage conversion ratio being less than or equal to a maximum voltage conversion ratio, perform at least one operation based on the second voltage conversion ratio.

6. The electronic device of any one of claims 1 to 5, wherein the controller is configured to reselect the charging current as the second voltage conversion ratio exceeds the maximum voltage conversion ratio.

7. The electronic device of any one of claims 1 to 6, wherein the controller is configured to identify the information related to the charging, based on communication with the power source.

8. The electronic device of any one of claims 1 to 7, further comprising a PDIC(power delivery integrated circuit) operatively and/or electrically connected to the connector and the controller,
   wherein the PDIC is configured to:

   identify the information related to the charging through USB(universal serial bus) PD(power delivery) communication with the power source, and
   provide a first signal related to the information related to the charging to the controller, and
   wherein the controller is configured to identify the information related to the charging, based on the first signal.

9. The electronic device of any one of claims 1 to 8, wherein the controller is configured to identify the information related to the charging, based on an impedance of the cable connected to the connector.

10. The electronic device of any one of claims 1 to 9, further comprising a PDIC operatively and/or electrically connected to the connector and the controller, wherein the PDIC is configured to:

    identify the impedance of the cable connected to the connector, and
    provide a second signal related to the impedance of the cable to the controller, and
    wherein the controller is configured to identify the information related to the charging, based on the second signal.

11. A method of operating an electronic device (100), the method comprising:

    identifying information related to charging;
    based on the information related to the charging, identifying a first voltage conversion ratio of a charging circuit (120) of the electronic device (100);
    based on the first voltage conversion ratio, controlling the charging circuit (120) to convert power provided through a connector (110) of the electronic device (100) for a connection with an external power source (190);
    while a battery (130) of the electronic device (100) is being charged based on the first voltage conversion ratio, identifying, based on the information related to the charging, a second voltage conversion ratio different from the first voltage conversion ratio of the charging circuit (120); and
    based on the second voltage conversion ratio, controlling the charging circuit (120) to convert power provided through the connector (110).

**12.** The method of claim 11, wherein the information related to the charging comprises at least one of information on an allowable current of a cable (191) connected to the connector (110) or information on an input current from the power source (190) to the electronic device (100).

**13.** The method of claim 11 or 12, wherein the identifying of the first voltage conversion ratio or the identifying of the second voltage conversion ratio comprises:

based on the information related to the charging, identifying a charging current for charging the battery (130);
based on the charging current, identifying a charging loss of the electronic device (100); and
based on the charging loss, identifying the first voltage conversion ratio or the second voltage conversion ratio.

**14.** The method of one of claims 11 to 13, wherein the identifying of the second voltage conversion ratio comprises:

based on the charging current, identifying an expected input current to be provided from the power source (190) while the battery (130) is being charged based on the first voltage conversion ratio; and
determining to change a voltage conversion ratio of the charging circuit (120) from the first voltage conversion ratio to the second voltage conversion ratio by comparing the expected input current to be provided from the power source (190) with the allowable current of the cable (191).

**15.** The method of one of claims 11 to 14, wherein the identifying of the second voltage conversion ratio comprises:

as the expected input current to be provided from the power source (190) exceeds the allowable current, identifying the second voltage conversion ratio; and
based on the second voltage conversion ratio being less than or equal to a maximum voltage conversion ratio, performing at least one operation, based on the second voltage conversion ratio.

FIG. 1

EP 4 723 425 A1

START

IDENTIFY CHARGING-RELATED INFORMATION — 201

IDENTIFY FIRST VOLTAGE CONVERSION RATIO — 203

CONTROL CHARGER CIRCUIT ACCORDING TO FIRST VOLTAGE CONVERSION RATIO — 205

CONVERT POWER, BASED ON FIRST VOLTAGE CONVERSION RATIO — 207

IDENTIFY SECOND VOLTAGE CONVERSION RATIO — 209

CONTROL CHARGER CIRCUIT ACCORDING TO SECOND VOLTAGE CONVERSION RATIO — 211

CONVERT POWER, BASED ON SECOND VOLTAGE CONVERSION RATIO — 213

END

FIG. 2

START

PERFORM COMMUNICATION THROUGH PDIC — 301

IDENTIFY CHARGING-RELATED INFORMATION
THROUGH COMMUNICATION — 303

PROVIDE SIGNAL FOR CHARGING-RELATED
INFORMATION TO CONTROLLER — 305

CONTROLLER IDENTIFIES CHARGING-RELATED
INFORMATION, BASED ON SIGNAL — 307

END

FIG. 3

START

IDENTIFY IMPEDANCE OF CABLE THROUGH PDIC — 401

PROVIDE SIGNAL FOR IMPEDANCE TO CONTROLLER — 403

CONTROLLER IDENTIFIES CHARGING-RELATED
INFORMATION, BASED ON SIGNAL — 405

END

FIG. 4

START

IDENTIFY CHARGING-RELATED INFORMATION — 501

IDENTIFY CHARGING CURRENT — 503

IDENTIFY CHARGING LOSS — 505

IDENTIFY VOLTAGE CONVERSION RATIO — 507

END

# FIG. 5

FIG. 6

FIG. 7

START

IDENTIFY VOLTAGE CONVERSION RATIO — 801

IDENTIFY INPUT CURRENT — 803

COMPARE INPUT CURRENT WITH ALLOWABLE CURRENT — 805

IDENTIFY VOLTAGE CONVERSION RATIO — 807

END

FIG. 8

START

IDENTIFY CHARGING CURRENT — 901

IDENTIFY N — 903

IDENTIFY INPUT CURRENT — 905

INPUT CURRENT ≤ ALLOWABLE CURRENT — 907

RESELECT CHARGING CURRENT — 917

N=N+1 — 911

N ≤ Nmax — 913

IS N SUPPORTABLE? — 915

YES

NO

NO

NO

YES

YES

CONVERT POWER, BASED ON N — 909

END

FIG. 9

FIG. 10

FIG. 11

FIG. 12

FIG. 13

FIG. 14

## INTERNATIONAL SEARCH REPORT

| International application No. |
| --- |
| **PCT/KR2024/008879** |

| A. | CLASSIFICATION OF SUBJECT MATTER |
| --- | --- |

**H02J 7/04**(2006.01)i; **H02J 7/00**(2006.01)i; **G01R 19/165**(2006.01)i; **G01R 27/16**(2006.01)i; **H01M 10/44**(2006.01)i

According to International Patent Classification (IPC) or to both national classification and IPC

| B. | FIELDS SEARCHED |
| --- | --- |

Minimum documentation searched (classification system followed by classification symbols)

H02J 7/04(2006.01); H02J 50/00(2016.01); H02J 50/10(2016.01); H02J 50/80(2016.01); H02J 7/00(2006.01); H02M 3/04(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 전자 장치(electronic device), 배터리(battery), 충전 회로(charging circuit), 전압 변환비(voltage conversion ratio)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | KR 10-2381432 B1 (SAMSUNG ELECTRONICS CO., LTD.) 01 April 2022 (2022-04-01)<br>See paragraphs [0016]-[0017] and [0121]; claims 1-2 and 28; and figure 4. | 1-3,11-13 |
| A | KR 10-2016-0105606 A (SAMSUNG ELECTRONICS CO., LTD.) 07 September 2016 (2016-09-07)<br>See paragraphs [0042]-[0130]; and figures 1-22. | 1-3,11-13 |
| A | KR 10-2019-0043611 A (HUAWEI TECHNOLOGIES CO., LTD.) 26 April 2019 (2019-04-26)<br>See paragraphs [0110]-[0263]; and figures 1-10. | 1-3,11-13 |
| A | KR 10-2019-0127886 A (GUANGDONG OPPO MOBILE TELECOMMUNICATIONS CORP., LTD.) 13 November 2019 (2019-11-13)<br>See paragraphs [0022]-[0219]; and figures 1-11. | 1-3,11-13 |
| A | KR 10-2021-0141297 A (BEIJING XIAOMI MOBILE SOFTWARE CO., LTD.) 23 November 2021 (2021-11-23)<br>See paragraphs [0055]-[0139]; and figures 1-15. | 1-3,11-13 |

☐ Further documents are listed in the continuation of Box C.　　☑ See patent family annex.

| * | Special categories of cited documents: |
| --- | --- |
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **04 October 2024** | **04 October 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT

International application No.

**PCT/KR2024/008879**

| Box No. II | Observations where certain claims were found unsearchable (Continuation of item 2 of first sheet) |

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☑ Claims Nos.: **4-10, 14-15**
because they are dependent claims and are not drafted in accordance with the second and third sentences of Rule 6.4(a).

Form PCT/ISA/210 (continuation of first sheet) (July 2022)

| INTERNATIONAL SEARCH REPORT | | International application No. |
|---|---|---|
| Information on patent family members | | PCT/KR2024/008879 |

| Patent document cited in search report | | | Publication date (day/month/year) | Patent family member(s) | | | Publication date (day/month/year) |
|---|---|---|---|---|---|---|---|
| KR | 10-2381432 | B1 | 01 April 2022 | CN | 107438935 | A | 05 December 2017 |
| | | | | CN | 107438935 | B | 02 July 2021 |
| | | | | CN | 113489171 | A | 08 October 2021 |
| | | | | CN | 113489171 | B | 21 November 2023 |
| | | | | EP | 3068017 | A2 | 14 September 2016 |
| | | | | EP | 3068017 | A3 | 04 January 2017 |
| | | | | EP | 3068017 | B1 | 05 May 2021 |
| | | | | EP | 3879672 | A1 | 15 September 2021 |
| | | | | EP | 3879672 | B1 | 11 May 2022 |
| | | | | EP | 4064521 | A2 | 28 September 2022 |
| | | | | EP | 4064521 | A3 | 16 November 2022 |
| | | | | EP | 4064521 | B1 | 01 May 2024 |
| | | | | KR | 10-2016-0110023 | A | 21 September 2016 |
| | | | | KR | 10-2020-0106482 | A | 14 September 2020 |
| | | | | KR | 10-2154779 | B1 | 10 September 2020 |
| | | | | US | 10326298 | B2 | 18 June 2019 |
| | | | | US | 11025082 | B2 | 01 June 2021 |
| | | | | US | 12015278 | B2 | 18 June 2024 |
| | | | | US | 2016-0268833 | A1 | 15 September 2016 |
| | | | | US | 2019-0305580 | A1 | 03 October 2019 |
| | | | | US | 2021-0288526 | A1 | 16 September 2021 |
| | | | | WO | 2016-144110 | A1 | 15 September 2016 |
| KR | 10-2016-0105606 | A | 07 September 2016 | CN | 105932725 | A | 07 September 2016 |
| | | | | CN | 105932725 | B | 17 July 2020 |
| | | | | KR | 10-2381085 | B1 | 01 April 2022 |
| | | | | US | 10270339 | B2 | 23 April 2019 |
| | | | | US | 2016-0254689 | A1 | 01 September 2016 |
| KR | 10-2019-0043611 | A | 26 April 2019 | CN | 107231014 | A | 03 October 2017 |
| | | | | CN | 107231014 | B | 19 February 2019 |
| | | | | EP | 3512066 | A1 | 17 July 2019 |
| | | | | EP | 3512066 | B1 | 15 June 2022 |
| | | | | JP | 2019-530412 | A | 17 October 2019 |
| | | | | JP | 6797291 | B2 | 09 December 2020 |
| | | | | KR | 10-2259113 | B1 | 31 May 2021 |
| | | | | US | 10819127 | B2 | 27 October 2020 |
| | | | | US | 2019-0222041 | A1 | 18 July 2019 |
| | | | | WO | 2018-054142 | A1 | 29 March 2018 |
| KR | 10-2019-0127886 | A | 13 November 2019 | CN | 108695921 | A | 23 October 2018 |
| | | | | CN | 108695921 | B | 02 June 2020 |
| | | | | CN | 108695998 | A | 23 October 2018 |
| | | | | CN | 108695998 | B | 31 January 2020 |
| | | | | CN | 108695999 | A | 23 October 2018 |
| | | | | CN | 108696302 | A | 23 October 2018 |
| | | | | CN | 108696302 | B | 15 June 2021 |
| | | | | CN | 108696849 | A | 23 October 2018 |
| | | | | CN | 108696849 | B | 08 January 2021 |
| | | | | CN | 108696948 | A | 23 October 2018 |
| | | | | CN | 108696948 | B | 22 September 2020 |
| | | | | CN | 109314396 | A | 05 February 2019 |
| | | | | CN | 109314396 | B | 19 July 2022 |

Form PCT/ISA/210 (patent family annex) (July 2022)

## INTERNATIONAL SEARCH REPORT
### Information on patent family members

International application No.

**PCT/KR2024/008879**

| Patent document cited in search report | Publication date (day/month/year) | Patent family member(s) | | | Publication date (day/month/year) |
|---|---|---|---|---|---|
| | | CN | 109417308 | A | 01 March 2019 |
| | | CN | 109417308 | B | 20 June 2023 |
| | | CN | 109478791 | A | 15 March 2019 |
| | | CN | 109787325 | A | 21 May 2019 |
| | | CN | 109787325 | B | 27 June 2023 |
| | | CN | 110089040 | A | 02 August 2019 |
| | | CN | 110089040 | B | 15 April 2022 |
| | | CN | 110100368 | A | 06 August 2019 |
| | | CN | 110100368 | B | 22 December 2023 |
| | | CN | 110100369 | A | 06 August 2019 |
| | | CN | 110100369 | B | 17 November 2023 |
| | | CN | 110121823 | A | 13 August 2019 |
| | | CN | 110121823 | B | 01 September 2023 |
| | | CN | 110121824 | A | 13 August 2019 |
| | | CN | 110121824 | B | 02 January 2024 |
| | | CN | 110168844 | A | 23 August 2019 |
| | | CN | 110168844 | B | 18 July 2023 |
| | | CN | 110168845 | A | 23 August 2019 |
| | | CN | 110168845 | B | 25 July 2023 |
| | | CN | 110168848 | A | 23 August 2019 |
| | | CN | 110168848 | B | 25 July 2023 |
| | | CN | 110168849 | A | 23 August 2019 |
| | | CN | 110168849 | B | 17 November 2023 |
| | | CN | 110168855 | A | 23 August 2019 |
| | | CN | 110168855 | B | 22 December 2023 |
| | | CN | 110178283 | A | 27 August 2019 |
| | | CN | 110178283 | B | 25 July 2023 |
| | | CN | 110192322 | A | 30 August 2019 |
| | | CN | 110192322 | B | 25 July 2023 |
| | | CN | 110199453 | A | 03 September 2019 |
| | | CN | 110199453 | B | 12 December 2023 |
| | | CN | 110214402 | A | 06 September 2019 |
| | | CN | 110214402 | B | 26 December 2023 |
| | | CN | 114784923 | A | 22 July 2022 |
| | | CN | 209472406 | U | 08 October 2019 |
| | | EP | 3462564 | A1 | 03 April 2019 |
| | | EP | 3462565 | A1 | 03 April 2019 |
| | | EP | 3462565 | B1 | 24 February 2021 |
| | | EP | 3493361 | A1 | 05 June 2019 |
| | | EP | 3493361 | B1 | 26 April 2023 |
| | | EP | 3582361 | A1 | 18 December 2019 |
| | | EP | 3582361 | B1 | 03 August 2022 |
| | | EP | 3591854 | A1 | 08 January 2020 |
| | | EP | 3591854 | B1 | 13 July 2022 |
| | | EP | 3595125 | A1 | 15 January 2020 |
| | | EP | 3595125 | B1 | 22 December 2021 |
| | | EP | 3605780 | A1 | 05 February 2020 |
| | | EP | 3605780 | B1 | 16 February 2022 |
| | | EP | 3605781 | A1 | 05 February 2020 |
| | | EP | 3605781 | B1 | 02 August 2023 |

Form PCT/ISA/210 (patent family annex) (July 2022)

## INTERNATIONAL SEARCH REPORT
### Information on patent family members

International application No.

**PCT/KR2024/008879**

| Patent document cited in search report | Publication date (day/month/year) | Patent family member(s) | | Publication date (day/month/year) |
|---|---|---|---|---|
| | | EP | 3609036 A1 | 12 February 2020 |
| | | EP | 3609036 B1 | 15 February 2023 |
| | | EP | 3609037 A1 | 12 February 2020 |
| | | EP | 3609037 B1 | 07 December 2022 |
| | | EP | 3609038 A1 | 12 February 2020 |
| | | EP | 3609038 B1 | 01 June 2022 |
| | | EP | 3609039 A1 | 12 February 2020 |
| | | EP | 3609039 B1 | 07 December 2022 |
| | | EP | 3609040 A1 | 12 February 2020 |
| | | EP | 3609040 B1 | 24 August 2022 |
| | | EP | 3609041 A1 | 12 February 2020 |
| | | EP | 3609041 B1 | 26 April 2023 |
| | | EP | 3609043 A1 | 12 February 2020 |
| | | EP | 3609043 B1 | 30 November 2022 |
| | | EP | 3609045 A1 | 12 February 2020 |
| | | EP | 3609045 B1 | 15 June 2022 |
| | | EP | 3609049 A1 | 12 February 2020 |
| | | EP | 3609049 B1 | 28 December 2022 |
| | | EP | 3751703 A1 | 16 December 2020 |
| | | JP | 2019-531685 A | 31 October 2019 |
| | | JP | 2020-506653 A | 27 February 2020 |
| | | JP | 2020-511102 A | 09 April 2020 |
| | | JP | 2020-511104 A | 09 April 2020 |
| | | JP | 2020-511108 A | 09 April 2020 |
| | | JP | 2020-512803 A | 23 April 2020 |
| | | JP | 2020-516220 A | 28 May 2020 |
| | | JP | 2020-516221 A | 28 May 2020 |
| | | JP | 2020-516222 A | 28 May 2020 |
| | | JP | 2020-516223 A | 28 May 2020 |
| | | JP | 2020-516224 A | 28 May 2020 |
| | | JP | 2020-517212 A | 11 June 2020 |
| | | JP | 2020-517213 A | 11 June 2020 |
| | | JP | 2021-132528 A | 09 September 2021 |
| | | JP | 2021-185738 A | 09 December 2021 |
| | | JP | 6812537 B2 | 13 January 2021 |
| | | JP | 6842566 B2 | 17 March 2021 |
| | | JP | 6871409 B2 | 12 May 2021 |
| | | JP | 6907327 B2 | 21 July 2021 |
| | | JP | 6918135 B2 | 11 August 2021 |
| | | JP | 6929959 B2 | 01 September 2021 |
| | | JP | 6952127 B2 | 20 October 2021 |
| | | JP | 6972159 B2 | 24 November 2021 |
| | | JP | 6987148 B2 | 22 December 2021 |
| | | JP | 6992080 B2 | 13 January 2022 |
| | | JP | 7013480 B2 | 31 January 2022 |
| | | JP | 7046094 B2 | 01 April 2022 |
| | | JP | 7059290 B2 | 25 April 2022 |
| | | JP | 7187632 B2 | 12 December 2022 |
| | | JP | 7203901 B2 | 13 January 2023 |
| | | KR | 10-2019-0038918 A | 09 April 2019 |

Form PCT/ISA/210 (patent family annex) (July 2022)

## INTERNATIONAL SEARCH REPORT
### Information on patent family members

International application No.

**PCT/KR2024/008879**

| Patent document cited in search report | Publication date (day/month/year) | Patent family member(s) | | Publication date (day/month/year) |
|---|---|---|---|---|
| | | KR 10-2019-0109568 | A | 25 September 2019 |
| | | KR 10-2019-0113984 | A | 08 October 2019 |
| | | KR 10-2019-0117722 | A | 16 October 2019 |
| | | KR 10-2019-0122800 | A | 30 October 2019 |
| | | KR 10-2019-0126398 | A | 11 November 2019 |
| | | KR 10-2019-0126870 | A | 12 November 2019 |
| | | KR 10-2019-0127887 | A | 13 November 2019 |
| | | KR 10-2019-0128685 | A | 18 November 2019 |
| | | KR 10-2019-0128706 | A | 18 November 2019 |
| | | KR 10-2019-0128707 | A | 18 November 2019 |
| | | KR 10-2019-0128708 | A | 18 November 2019 |
| | | KR 10-2222153 | B1 | 03 March 2021 |
| | | KR 10-2243241 | B1 | 22 April 2021 |
| | | KR 10-2264015 | B1 | 11 June 2021 |
| | | KR 10-2268987 | B1 | 24 June 2021 |
| | | KR 10-2269323 | B1 | 25 June 2021 |
| | | KR 10-2318241 | B1 | 27 October 2021 |
| | | KR 10-2325154 | B1 | 11 November 2021 |
| | | KR 10-2325155 | B1 | 11 November 2021 |
| | | KR 10-2328496 | B1 | 17 November 2021 |
| | | KR 10-2335722 | B1 | 06 December 2021 |
| | | KR 10-2397746 | B1 | 12 May 2022 |
| | | KR 10-2424046 | B1 | 21 July 2022 |
| | | KR 10-2445168 | B1 | 19 September 2022 |
| | | US 10998751 | B2 | 04 May 2021 |
| | | US 11075542 | B2 | 27 July 2021 |
| | | US 11171499 | B2 | 09 November 2021 |
| | | US 11196305 | B2 | 07 December 2021 |
| | | US 11196306 | B2 | 07 December 2021 |
| | | US 11201509 | B2 | 14 December 2021 |
| | | US 11233423 | B2 | 25 January 2022 |
| | | US 11345467 | B2 | 31 May 2022 |
| | | US 11349349 | B2 | 31 May 2022 |
| | | US 11349350 | B2 | 31 May 2022 |
| | | US 11355963 | B2 | 07 June 2022 |
| | | US 11355969 | B2 | 07 June 2022 |
| | | US 11368050 | B2 | 21 June 2022 |
| | | US 11394250 | B2 | 19 July 2022 |
| | | US 11437848 | B2 | 06 September 2022 |
| | | US 11437865 | B2 | 06 September 2022 |
| | | US 11515736 | B2 | 29 November 2022 |
| | | US 11539219 | B2 | 27 December 2022 |
| | | US 11631985 | B2 | 18 April 2023 |
| | | US 2019-0140466 | A1 | 09 May 2019 |
| | | US 2019-0140470 | A1 | 09 May 2019 |
| | | US 2019-0190321 | A1 | 20 June 2019 |
| | | US 2019-0356153 | A1 | 21 November 2019 |
| | | US 2019-0356154 | A1 | 21 November 2019 |
| | | US 2019-0356156 | A1 | 21 November 2019 |
| | | US 2019-0372387 | A1 | 05 December 2019 |

Form PCT/ISA/210 (patent family annex) (July 2022)

**INTERNATIONAL SEARCH REPORT**
Information on patent family members

International application No.

**PCT/KR2024/008879**

| Patent document cited in search report | | | Publication date (day/month/year) | Patent family member(s) | | | Publication date (day/month/year) |
|---|---|---|---|---|---|---|---|
| | | | | US | 2019-0372404 | A1 | 05 December 2019 |
| | | | | US | 2019-0379245 | A1 | 12 December 2019 |
| | | | | US | 2019-0386516 | A1 | 19 December 2019 |
| | | | | US | 2020-0014235 | A1 | 09 January 2020 |
| | | | | US | 2020-0014252 | A1 | 09 January 2020 |
| | | | | US | 2020-0021129 | A1 | 16 January 2020 |
| | | | | US | 2020-0021130 | A1 | 16 January 2020 |
| | | | | US | 2020-0021148 | A1 | 16 January 2020 |
| | | | | US | 2020-0036215 | A1 | 30 January 2020 |
| | | | | US | 2020-0036216 | A1 | 30 January 2020 |
| | | | | US | 2020-0412180 | A1 | 31 December 2020 |
| | | | | US | 2022-0029440 | A1 | 27 January 2022 |
| | | | | WO | 2018-184573 | A1 | 11 October 2018 |
| | | | | WO | 2018-184578 | A1 | 11 October 2018 |
| | | | | WO | 2018-184581 | A1 | 11 October 2018 |
| | | | | WO | 2018-184582 | A1 | 11 October 2018 |
| | | | | WO | 2018-184583 | A1 | 11 October 2018 |
| | | | | WO | 2018-184584 | A1 | 11 October 2018 |
| KR | 10-2021-0141297 | A | 23 November 2021 | CN | 111597286 | A | 28 August 2020 |
| | | | | CN | 111597286 | B | 23 June 2023 |
| | | | | CN | 113675900 | A | 19 November 2021 |
| | | | | EP | 3910749 | A1 | 17 November 2021 |
| | | | | JP | 2021-167816 | A | 21 October 2021 |
| | | | | JP | 2021-180603 | A | 18 November 2021 |
| | | | | JP | 7228554 | B2 | 24 February 2023 |
| | | | | JP | 7300477 | B2 | 29 June 2023 |
| | | | | KR | 10-2532828 | B1 | 15 May 2023 |
| | | | | KR | 10-2587827 | B1 | 10 October 2023 |
| | | | | US | 11881737 | B2 | 23 January 2024 |
| | | | | US | 2021-0359535 | A1 | 18 November 2021 |
| | | | | WO | 2021-227235 | A1 | 18 November 2021 |
| | | | | WO | 2021-228185 | A1 | 18 November 2021 |

Form PCT/ISA/210 (patent family annex) (July 2022)